(19)

Europäisches
Patentamt
European
Patent Office
Office européen
des brevets

(11) **EP 4 290 776 A1**

(12) **EUROPEAN PATENT APPLICATION**

(43) Date of publication:
**13.12.2023 Bulletin 2023/50**

(21) Application number: **22177819.4**

(22) Date of filing: **08.06.2022**

(51) International Patent Classification (IPC):
**H03M 13/11** (2006.01)    **H03M 13/37** (2006.01)

(52) Cooperative Patent Classification (CPC):
**H03M 13/112; H03M 13/114; H03M 13/3707;
H03M 13/3723; H03M 13/658**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **Nokia Solutions and Networks Oy
02610 Espoo (FI)**
• **Consiglio Nazionale Delle Ricerche
00185 Roma (IT)**

(72) Inventors:
• **FERRARI, Marco
20139 Milan (IT)**
• **TARABLE, Alberto
10091 Alpignano (IT)**

• **BARLETTA, Luca
20134 Milano (IT)**
• **GAVIOLI, Giancarlo
20864 Arcore (IT)**
• **RAZZETTI, Luca Gabriele
20099 Sesto San Giovanni (IT)**
• **COSTANTINI, Carlo
23880 Casatenovo (IT)**
• **CAOBIANCO, Sara
23899 Robbiate (IT)**
• **CUCCHI, Daniele
20083 Milan (IT)**
• **CATTANEO, Davide
20871 Seregno (IT)**

(74) Representative: **Nokia EPO representatives
Nokia Technologies Oy
Karakaari 7
02610 Espoo (FI)**

(54) **LOW-DENSITY PARITY-CHECK DECODER WITH SCALING TO REDUCE POWER
CONSUMPTION**

(57)    A method and apparatus are provided for decoding a plurality of codewords from a received binary bitstream, for example LDPC codewords. A first decoding stage processes each of the codewords with a first iterative decoding algorithm based on forward error-correction information of the codewords, for example a scaled min-sum decoding algorithm employing a first scaling strategy. A second decoding stage, for example a scaled min-sum decoding algorithm employing a second scaling strategy, processes selected ones of the codewords with a second iterative decoding algorithm, which is based on forward error-correction information in the selected ones of the codewords. Each codeword selected for the second decoding stage is selected in response to an exit from the decoding of that codeword without the production of a decoded codeword. The second iterative decoding algorithm is configured to enable a greater number of iterations of decoding per codeword than the first iterative decoding algorithm.

*FIG. 1*

EP 4 290 776 A1

## Description

### Technical Field

The subject matter of the present disclosure relates to methods and apparatus for decoding messages that have been optically transmitted using low-density parity-check (LDPC) codes.

### Art Background

This section introduces aspects that may be helpful to facilitating a better understanding of the invention. Accordingly, the statements of this section are to be read in this light and are not to be understood as admissions about what is prior art or what is not the prior art.

In digital communication, and especially in coherent optical communication, techniques of forward error correction (FEC) techniques are usefully employed to recover from errors in transmitted digital data that occur due to random noise and other transmission impairments. Forward error-correcting codes add redundancy to the transmitted messages. At the receiver, the redundancy typically makes it possible for a decoder to detect and correct at least some of the errors without requiring the messages to be retransmitted.

Forward error-correcting codes are broadly subdivided into convolutional codes, which operate on bit streams of arbitrary length, and block codes, which operate on bit sequences, or "blocks", of fixed length. Low-density parity-check (LDPC) codes, which are block codes, have attracted interest because, among other things, they can be decoded with low complexity; more specifically, they can be decoded in time that grows linearly relative to the block length. Some LDPC codes also offer advantages in performance at high code rates and under channel conditions of relatively low noise.

At the receiver, LDPC-encoded messages are typically decoded by a *soft-decision* decoder, which uses techniques of statistical inference in an iterative process to decide on the corrected bit values. Notionally, each bit of a received codeword has a reliability metric, which is indicative of a level of belief that the true bit value is 0. In each iteration, this metric for the respective bits is updated, using parity constraints on the bits that have been built into the code. The updated reliability metrics can be invoked to assign a 1 or a 0 to each bit. If the updated binary values satisfy the parity condition, the process terminates for that codeword. Otherwise, the process continues for another iteration, unless a preset limit on the number of iterations has been reached.

The above description of a decoding process is meant only as a broad outline offered for pedagogical purposes. In practical applications, there are numerous variations and alternative implementations that deviate in large and small ways from the steps described above.

One well-known type of algorithm for an LDPC decoder is the log-likelihood ratio sum-product algorithm (LLR-SPA). LLR-SPA algorithms can achieve excellent capacity performance. However, they compute reliability metrics in terms of log-likelihood ratios (LLRs). These computations have relatively high complexity, which can lead to undesirably high decoding delay. This problem has been addressed by various lower-complexity approximations. One of the most important of these is the Min-Sum (MS) approximation, which estimates the log-likelihood ratio using a minimum-search operation in place of the more complex exact computations, which involve the hyperbolic tangent and its inverse function.

Although algorithms based on the MS approximation are useful, the approximation leads to some loss of information. Further, treating an estimate as though it represented a true probability tends to degrade the performance of the decoder.

Various design modifications have been proposed to reduce the error rate and improve performance, while avoiding an unacceptable increase in the decoding complexity. In one such approach, referred to as Scaled Min-Sum, the estimated LLR is modified by applying a scaling function to it in order to decrease the error rate. In some examples, a mapped value of the LLR under the scaling function may be obtained by applying a multiplicative coefficient obtained from a look-up table (LUT). In other cases, alternative methods for obtaining the mapped value may be used. Generally, the LLR is mapped under the scaling function to a smaller value. Thus, for example, it is multiplied by a scaling coefficient that is less than 1.

As is known in the art, an optimum scaling function would depend on the signal-to-noise ratio (SNR) of the transmission channel and on the structure of the particular LDPC code. Scaling can also be designed to change at each iteration and to adapt to the evolution of the probability density of messages over the several iterations, so that in practice, the scaling function depends on the iteration number. Because the scale factors affect the rate of convergence of the iterative procedure, the scaling function may also be designed according to a specified number of iterations to convergence. Because of these and other complexities, it is known in the art to implement the scaling function in the form of a look-up table (LUT).

Investigators have proposed various scaling methodologies that range from exhaustive searching for suitable scale factors to more analytical approaches for constructing a scaling function. For example, A. Alvarado et al., "Correcting Suboptimal Metrics in Iterative Decoders," 2009 IEEE International Conference on Communications (2009) 1-6, describes a methodology reliant on the distribution of the soft information exchanged in the iterative process.

Some investigators have proposed a methodology in which the scale factor is a constant multiplier for a given set of parameters such as the code, the channel SNR, and the iteration number.

LDPC codes are well-suited for use in digital communication, among other applications, because they can approach the best achievable performance with reasonable computational complexity. In selecting an error-correcting code, a system designer typically considers a tradeoff between complexity, which affects chip area and power consumption, and performance, understood as the ability to correct errors in critical noise conditions. LDPC codes are valuable in this regard because they can work with decoders of different types.

As noted above, an LDPC decoder can be designed with complexity that increases only linearly with the block size. However, the price of this advantage is the need for iterations in the decoding process. Power consumption increases linearly with the number of iterations. Hence, if all iterations consume the same amount of energy, fewer of the iterations will typically mean less power consumption by the receiver to correct the errors. In view of this, system designers may attempt to minimize the iteration number, as averaged over many different data blocks, in order to economize on power consumption.

The MS approximation, scaling, and other refinements have been proposed as approaches for reducing the required number of iterations. However, there remains a need for new approaches that can further increase the power efficiency of LDPC decoding, while maintaining a desired level of decoder performance.

## Summary of the Disclosure

In a first aspect, the disclosed subject matter relates to method for decoding a plurality of codewords from a received binary bitstream. The codewords may, for example, be LDPC-encoded codewords.

In a first decoding stage, the disclosed method processes each of the codewords with a first iterative decoding algorithm based on forward error-correction information of the codewords. In a second decoding stage, the method processes selected ones of the codewords with a second iterative decoding algorithm, which is based on forward error-correction information in the selected ones of the codewords. The first and second decoding stages may, for example, each process codewords with a scaled MS decoding algorithm.

Each codeword that is selected for the second decoding stage is selected in response to the event that the decoding of that codeword is exited without producing a decoded codeword. The second iterative decoding algorithm is configured to enable a greater number of iterations of decoding per codeword than the first iterative decoding algorithm.

In implementations, each of the selected ones of the codewords is selected in response to an indication, in the processing of the first decoding stage, that a preset maximum number of iterative decoding attempts has been made thereon without producing a successful decoding.

In implementations, individual ones of the codewords are checked periodically during the processing of the first decoding stage to determine whether their decoding has been successful; and for each individual one of the codewords, the processing of the first decoding stage is exited upon the earlier of two events, namely, when a determination is made that the individual one of the codewords has been successfully decoded, or when a determination is made that a preset maximum number of decoding iterations has been reached for the individual one of the codewords .

In implementations, the first decoding stage and the second decoding stage each process codewords with a scaled MS decoding algorithm having a respective scaling strategy; and the scaling strategy for the second decoding stage is designed to enable a greater number of decoding iterations than the scaling strategy for the first decoding stage.

In implementations, at least one of the first and second decoding stages uses flood scheduling or sequential scheduling.

In implementations, at least the second decoder uses dynamic scaling.

In implementations, the second decoding stage is designed to decode with a smaller error rate than the first decoding stage, at a given channel quality.

In implementations, the first decoding stage processes codewords with a scaled MS decoding algorithm that takes values indicative of a scaled posterior LLR from a first look-up table (LUT); the second decoding stage processes codewords with a scaled MS decoding algorithm that takes values indicative of a scaled posterior LLR from a second look-up table (LUT); the first and second LUTs are each designed to implement a respective scaling strategy; and the scaling strategy implemented by the second LUT enables a greater number of decoding iterations per codeword than the scaling strategy implemented by the first LUT.

In implementations, each codeword that is in-process in the first decoding stage undergoes at least one decoding iteration;

each decoding iteration in the first decoding stage updates posterior LLR values for bits of the in-process codeword; and before any selected one of the codewords is processed with the second iterative decoding algorithm, the bits of the selected one of the codewords are reset to initial LLR values. The initial LLR values are LLR values that were associated with the respective bits prior to processing in the first decoding iteration in the first decoding stage.

In various implementations, a received, LDPC-encoded, data-modulated optical signal is converted to the binary bitstream in a coherent optical receiver. The binary bitstream is then advanced to the first decoding stage.

In a second aspect, the subject matter of the present disclosure relates to apparatus comprising a decoder circuit and a codeword memory. The decoder circuit is configured to decode codewords using an iterative algorithm, i.e., an algorithm that is performed in decoding iterations. The codeword memory is configured to store a portion of the codewords, i.e., some or all of the codewords, in response to said portion having failed to be decoded by the decoder circuit, in a first decoding stage, after a preset maximum permitted number of the decoding iterations of the algorithm. The decoder circuit is further configured to process codewords of the stored portion in a second decoding stage in response to retrieving the codewords of said portion from the codeword memory.

In implementations, the decoder circuit is further configured to exit the decoding iterations on each codeword that is in-process in the first decoding stage upon the earlier of two events, namely, a determination that the in-process codeword has been successfully decoded, and a determination that a preset maximum permitted number of decoding iterations has been reached thereon. The decoder circuit is further configured to store the in-process codeword in the codeword memory for processing in the second decoding stage, if the preset maximum permitted number of decoding iterations has been reached thereon.

In implementations, the apparatus further comprises an LUT circuit and a memory for storing a first look-up table (LUT) and a second look-up table (LUT). The LUT circuit is configured to retrieve a set of values indicative of scaled posterior LLRs from the first look-up table memory and to retrieve a different set of values indicative of scaled posterior LLRs from the second look-up table memory. The LUT circuit is further configured to provide values from the first LUT to the decoder circuit for use in the first decoding stage, to provide values from the second LUT to the decoder circuit for use in the second decoding stage, and to reset bits of each codeword retrieved from the codeword memory to initial LLR values before each said retrieved codeword is processed in the second decoding stage. The initial values are respective values that the bits of the retrieved codeword had prior to the processing thereof in the first decoding stage.

## Brief Description of the Drawings

FIG. 1 is a simplified flowchart illustrating a possible architecture for a serial-C, discrete MS decoder.

FIG. 2 is a flowchart illustrating an exemplary method of operating the decoder of FIG. 1.

FIG. 3 is a graph showing the evolution of the word error rate (WER) as the relative number of iterations increases in example implementations of a decoding scheme as described here.

FIG. 4A is a simplified, functional block diagram showing the optical front end of a polarization and phase diversity, coherent optical receiver in a non-limiting example.

FIG. 4B is a simplified, functional block diagram of the functional subsystems of a coherent optical receiver that may be implemented in a digital signal processor (DSP).

## Detailed Description

Incorporation by reference. The entirety of each of the following publications is hereby incorporated herein by reference:

A. Alvarado et al., "Correcting Suboptimal Metrics in Iterative Decoders," 2009 IEEE International Conference on Communications (2009) 1-6;

E. Sharon, S. Litsyn and J. Goldberger, "Efficient Serial Message-Passing Schedules for LDPC Decoding," in IEEE Transactions on Information Theory, vol. 53, no. 11, (Nov. 2007) 4076-4091

Emna Ben Yacoub, "Matched Quantized Min-Sum Decoding of Low-Density Parity-Check Codes", Proc. 2020 IEEE Information Theory Workshop (ITW), (11-15 April 2021); and

A. Balatsoukas-Stimming and A. Burg, "Density evolution for min-sum decoding of LDPC codes under unreliable message storage", IEEE Commun. Letters, 18(5) (May 2014) 849-852.

Technical background. The codewords of an LDPC code of length $n$ and rank $k$, i.e., of an $(n, k)$ code, are strings of $n$ bits each. The codewords must all satisfy a parity condition, which can be formulated in terms of a sparse, binary-valued matrix **H**. The matrix **H** represents a set of $n-k$ parity-check constraints, each of which is a requirement that some selection from the full sequence of codeword bits must sum to 0, modulo-2.

At the receiver, the parity-check constraints can be used to correct bit errors in the received block. Each bit position in the received block is subject to some subset of the $n-k$ constraints, and each constraint involves a different subset of the bit positions in the block. Each constraint may be interpreted as a requirement for the affected bits to sum to 0, modulo 2. A decoder may use an iterative procedure to update information about each of the bits in the received block in repeated cycles, until the constraints are all satisfied, or until a limit on the number of iterations is reached.

A *soft-decision* decoder, as noted above, uses techniques of statistical inference to decide on the corrected bit values. This inference is based on reliability metrics, such as LLRs, that are updated in each of multiple iterations, subject to the parity constraints built into the code. Because each constraint dictates that some collection of bits must sum to 0, it follows that the reliability metric for a given bit can be updated by considering the reliability metrics of all of the *other* bits that relate to the given bit through a parity-check constraint.

LDPC decoders implement a sub-category of processes known as belief propagation (BP) algorithms. LLR-SPA, for example, is a type of BP algorithm. A typical feature of a BP algorithms is that, conceptually, it involves the passing of messages between nodes of a bipartite graph. In the LDPC decoder, messages are passed, conceptually, between *variable* nodes, representing the bits of the received block, and *check* nodes, representing the constraints. Each check node has a *neighborhood,* consisting of all of the variable nodes subject to the constraint that check node represents. Likewise, each variable node has a neighborhood, consisting of all of the check nodes to whose respective constraints that variable node is subject.

In graphical terms, each check node is connected by an edge of the graph to each variable node in its neighborhood, and each variable node of the graph is connected by an edge to each check node in its neighborhood. Conceptually, the messages, which contain reliability metrics, are effectively passed between variable nodes and check nodes along the edges of the graph.

Another feature of a BP algorithm is that for each of the variables to be inferred, it calculates marginal probability distributions that are conditional on observed values. In the graphical conceptualization described above, the check nodes effectively calculate, in each iteration, marginal probability distributions that are the basis for the reliability metrics returned to the respective variable nodes.

For numerical stability and for economy in computational time, it is advantageous to perform the necessary statistical calculations in the logarithmic domain. Hence, the distributions are typically described using log-likelihood ratios (LLRs).

We will now briefly discuss the LLR-SPA. We introduce the following notation:
$R_i$ denotes the log-likelihood ratio (LLR) of bit $i$ derived from the observations.

At iteration $k$, $E_{j \rightarrow i}^{(k)}$ is the LLR of bit $i$ which is sent from check node $j$ to variable node $i$. It is defined if and only if the variable node $i$ and the check node $j$ are connected by an edge.

At iteration $k$, $M_{j \leftarrow i}^{(k)}$ is the LLR of bit $i$ which is then sent from variable node $i$ to check node $j$. It is defined if and only if the variable node $i$ and the check node $j$ are connected by an edge. $E_{j \rightarrow i}^{(k)}$, sometimes referred to as the "L-value", is given by:

$$E_{j \rightarrow i}^{(k)} = 2\tanh^{-1}\left( \prod_{i' \neq i} \tanh\left( \frac{M_{j \leftarrow i'}^{(k-1)}}{2} \right) \right). \qquad (I)$$

$M_{j \leftarrow i}^{(k)}$ is given by:

$$M_{j \leftarrow i}^{(k)} = R_i + \sum_{j' \neq j} E_{j' \rightarrow i}^{(k)}. \qquad (II)$$

As noted above, the Min-Sum (MS) approximation reduces the complexity of the above computations by using a minimum-search operation in place of the more complex computations involving the hyperbolic tangent and its inverse function.

In the MS approximation, the updating rule in Equation (I) is replaced with the following:

$$E_{j \rightarrow i}^{(k)} = \prod_{i' \neq i} \text{sgn}\left( M_{j \leftarrow i'}^{(k-1)} \right) \min_{i' \neq i} \left| M_{j \leftarrow i'}^{(k-1)} \right|. \qquad (III)$$

As explained above, this approximation can degrade the performance of the decoder. Scaled Min-Sum algorithms have been designed to decrease the error by using a scaling function, which is typically implemented by a lookup table (LUT). An example approach based on scaling will be described below.

In each iteration of a known message-passing schedule for LDPC decoders known as a "flooding" schedule, all the variable nodes, and then all the check nodes, pass new messages to their neighbors. An alternative type of schedule, known as a "serial" schedule, is also known in the art. Serial schedules enable immediate propagation of messages, which can result in faster convergence.

A serial-C schedule, for example, is based on a serial update of the messages effectively received and sent by the check nodes. A sequential ordering is devised for the check nodes. Effectively, for each check node, in turn, the neighboring variable nodes send their messages to the check node, and then the check node sends its messages to the neighboring variable nodes. The procedure then passes to the next check node in sequence.

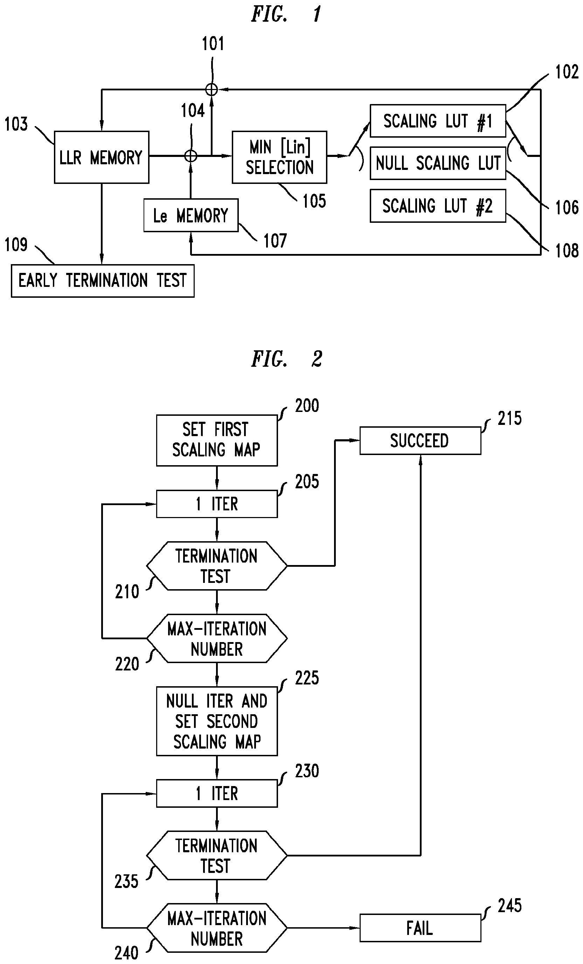

FIG. 1, for example, is a simplified flowchart illustrating a possible architecture for a serial-C, discrete MS decoder. To simplify the discussion, we consider a single check node $CN_j$. Memory 103 holds the *posterior* LLR of each variable node connected to $CN_j$. Each of these posterior LLRs is computed, in iteration $k$, by the summation at block 101 of input messages $L_{in}$ input to the check node at iteration $k$, and output messages Le output by the check node at iteration $k$.

Memory 107 holds a set of *extrinsic* LLRs, denominated Le, which are sent from the check node to the variable nodes in its neighborhood. For the $k$th iteration, each Le is derived from the quantity

$$\text{Min } |L_{in}| = \min_{i' \neq i} \left| M_{j \leftarrow i'}^{(k-1)} \right|$$

, as will be explained further below. The quantities $L_{in} = M_{j \leftarrow i}^{(k)}$, are the input messages sent to check node $j$ from the variable nodes in its neighborhood.

At the $k$th iteration, the decoder accesses memory 103 and reads, from there, the posterior LLRs of the variable nodes connected to $CN_j$. For each variable node $i$, the previous check-node output Le for variable node $i$ is subtracted from the posterior LLR at node 104. Thus, there is computed, at node 104, an *input* set of *extrinsic* LLRs that are sent in messages to the check node from the variable nodes in its neighborhood.

This previous check-node output, referred to here as Le, is, to within a sign, a scaled version of the quantity,

$$\text{Min } |L_{in}| = \min_{i' \neq i} \left| M_{j \leftarrow i'}^{(k-1)} \right|.$$

New $|L_{in}|$ values are computed, and for each variable node in the $CN_j$ neighborhood, a new Min $|L_{in}|$ is computed at block 105. The quantity $\prod_{i' \neq i} \text{sgn}\left( M_{j \leftarrow i'}^{(k)} \right) \text{Min } |L_{in}|$ is scaled at block 102, 106, or 108, and stored in Le memory 107 as a new check-node output. The scaling will be discussed in more detail below. The LLR memory 103 is updated. At the end of the iteration, an early termination test is performed at block 109.

Simulation studies have indicated that serial decoders can often converge in about half the number of iterations that are needed with flooding schedules. In practice, this can reduce the amount of processing hardware that is needed by about half, and it can also reduce the memory requirements. LDPC decoding with a serial-C schedule is discussed, for example, in E. Sharon, S. Litsyn and J. Goldberger, "Efficient Serial Message-Passing Schedules for LDPC Decoding," in IEEE Transactions on Information Theory, vol. 53, no. 11, (Nov. 2007) 4076-4091.

Scaling functions that seek the best achievable performance are typically designed with the smallest scaling coefficients, so that the messages are updated with a greater degree of caution. Performance, in this regard, is typically measured by the *convergence threshold*, i.e., the lowest channel quality that still allows the decoder to converge. Channel quality is typically expressed as signal-to-noise ratio (SNR), although it may equivalently be expressed as E/N, i.e., as the energy per bit, divided by the noise power spectral density. More formally, then, the convergence threshold is the minimum SNR value beyond which the probability mass functions (pmfs) of the messages evolve toward error-free distributions within the desired number of iterations. A pmf, sometimes referred to as a "discrete density function", is a function that gives the probability that a discrete random variable is exactly equal to some value, such as the value 0 or 1 in the present example.

However, cautious scaling with small coefficients tends to increase the average number of iterations needed to complete the decoding process. Larger scaling coefficients, on the other hand, tend to speed up the decoding process, although there is a penalty, because sometimes convergence may be lost, leading to a degradation in performance. This tradeoff has been addressed by proposals to employ a dynamic scaling strategy in which the scaling can vary from iteration to iteration in a manner that adapts as the probability density of the messages evolves.

In this regard, Discrete Density Evolution (DDE) is a technique that tracks the average probability density functions (pdfs) of the messages effectively exchanged between the variable and check nodes as they change from one iteration to the next. DDE assumes that all messages are independent, as it operates in the limit of infinite block length. The scaling function can be involved because it maps the probabilities of pre-scaling values into those of post-scaling values.

The application of DDE begins with the pmfs of the input messages, which typically are obtained from a channel model. A typical model for this purpose is the well-known channel with additive white noise, i.e., the AWGN model. The DDE can be extended to a scaled-MS decoder, for example, by taking into account the scaling law which maps the probability of pre-scaling values into that of post-scaling values. The paper by E. Ben Yacoub and the paper by A. Balatsoukas-Stimming et al., both cited above, may be of particular interest in regard to applications of DDE for scaling design.

<u>Doubly scaled decoding.</u> We have devised a new approach to the scaling problem that has the potential to both reduce computational complexity and provide high performance, relative to some conventional scaling strategies. Our new approach may be useful with various LDPC codes. Also, the new approach may be useful with various scaling designs. Although an example provided below uses DDE to design the scaling for serial-C scaled MS decoding, the example is for purposes of illustration and does not limit the scope of our inventions.

Various embodiments of our method employ a combination of two scaling strategies. At an initial stage, a scaling, which typically converges rapidly, is used for decoding codewords with a relatively small average number of iterations. A second decoding stage is entered after a reset, which is described below. The second decoding stage is used to decode a portion, typically some, but possibly all, of the codewords. The scaling in the second decoding stage typically achieves a desired performance, such as a desired convergence SNR threshold. The second decoding stage will generally employ a cautious decoding strategy, in the sense that it is designed for a greater number of iterations per codeword than the first decoding stage, but is also expected to achieve a higher level of performance.

The initial stage employs a test to determine when a codeword has been successfully decoded, so that the decoding iterations for that codeword can be halted. The various embodiments pass to the second stage only those codewords that failed to be successfully decoded in the initial stage. In typical instances, the number of codewords that are successfully decoded in the first stage is expected, by the inventors, to far exceed the number of codewords that are passed to the second stage in the various embodiments. Hence, a desired performance level is expected to often be achieved with a lower average number of iterations than would be required if all codewords were subjected only to the second stage of decoding.

In an illustrative example, both stages are performed by serial-C scaled-MS decoding. Turning again to FIG. 1, it will be seen that the Min $|L_{in}|$ output from block 105 is scaled by a scaling function implemented with a coefficient or mapped value selected from one of three LUTs, labeled in the figure as "LUT #1" (block 102), "null scaling LUT" (block 106), and "LUT #2" (block 108). LUT #1 is used in the stage-1 decoding, and LUT #2 is used in the stage-2 decoding.

In the serial-C scaled-MS decoder, a step of running a single iteration with null scaling coefficients is performed to reset, to their original input values, those messages that failed to decode at the initial decoding stage. That is, those messages are reset to the original input messages. Accordingly, the null scaling LUT is selected for a single iteration after the initial stage 1, so as to reset those messages to their original input values before commencing the cautious decoding of stage 2.

FIG. 2 provides a flowchart illustrating an exemplary method of operating the decoder of FIG. 1. The flowchart is an example and does not exclude numerous alternative ways in which the illustrated method could be implemented by a skilled person having the knowledge of the present disclosure.

Prior to performing the method of FIG. 2, a scaling map, which implements a scaling function, is defined at block 200 for LDPC decoding stage-1. For example, the scaling map may be stored in a LUT.

At block 205, the method of FIG. 2 includes performing a first or subsequent iteration of the stage-1 decoding.

At block 210, after each stage-1 iteration, the method of FIG. 2 includes performing an early termination test to determine whether the stage-1 decoding has successfully decoded a codeword, so that decoding can be terminated for this codeword. The early termination test involves checking the decoding result for the codeword of the present iteration against the set of parity checks for the corresponding LPDC code, as has been schematically explained in our description, above, of the bipartite graph representation of iterative decoding schemes for LPDPC codes. A decoding result for a codeword passes the early termination test if the decoding result satisfies all of the parity constraints of the specific LDPC code.

If the results of the early termination test indicate a decoding success, the method includes outputting the decoded codeword, at block 215.

If the results of the early termination test do not indicate a decoding success, the method includes determining, at control block 220, whether a preset maximum number of stage-1 decoding iterations has been reached for the particular codeword. If the preset maximum number has not been reached, a new iteration of stage-1 decoding is initiated on the decoding result of the present iteration, at block 205. If the preset maximum number of iterations has been reached, the method includes, at block 225, performing a single decoding iteration with null scaling coefficients. The effect of this iteration is to reset the codeword to its as-received condition, i.e., its condition prior to stage-1 decoding. In this condition, the codeword is suitable for stage-2 decoding.

As also indicated at block 225, the method further includes defining the scaling map for the stage-2 decoding. At block 230, the method includes performing a first or subsequent iteration of the stage-2 decoding, with its respective scaling, on the reset codeword output from block 225.

After each iteration of stage-2 decoding, the method includes performing an early termination test, as indicated at block 235. The early termination test involves checking the codeword bits resulting from the present iteration against the set of parity checks for the corresponding LPDC code, as schematically explained above in reference to bipartite graph representations of iterative decoding schemes for LDPC codes.

If the result of the early termination test of block 235 indicates a successfully decoded codeword, the method outputs the decoded codeword at block 215 as the stage-2 decoding result for this codeword. If the result of the early termination test of block 235 does not indicate a successful decoding, the method includes, at block 240, determining whether the preset maximum number of iterations for stage-2 decoding of this codeword has been reached. If the preset maximum number of iterations has not been reached, the method includes returning to block 230 to start a new stage-2 decoding iteration. If the preset maximum number of iterations for stage-2 decoding of this codeword has been reached, the method includes indicating, at block 245, a decoding failure, for this codeword.

In embodiments of the above-described two-stage, iterative LDPC decoding method, the inventors expect that most decoding results will satisfy the early termination test in the stage-1 decoding prior to reaching the preset maximum number of iterations. Thus, the average number of iterations for decoding a codeword is likely to be reduced by the two-stage method. The cost is that in general, the number of iterations will be higher for the second decoding stage than for the first decoding stage. However, since most codewords are expected to be decodable by the stage-1 decoding, the increased length of the stage-2 decoding of "some" codewords is expected to cause only a modest increase in the average number of iterations needed to decode a codeword, while achieving a high performance level.

Implementation details. As explained above in reference to FIG. 2, respective LUTs are defined, in example implementations, for the stage-1 decoding and for the stage-2 decoding. Any of various methodologies may be employed for defining the LUTs. It is desirable, however, that the stage-2 LUT should be designed for a greater number of iterations than the stage-1 LUT. Generally, a scaling strategy designed for a greater number of iterations would be expected to result in a smaller error rate, such as a smaller word error rate (WER), for a given channel quality. A combination of lower complexity in stage 1 with better error performance in stage 2 will often be advantageous.

In simple cases, the WER can be predicted from theory for a given code and decoder, given sufficient knowledge of the channel characteristics. More generally, the WER can be estimated by simulation. Thus, it will in at least some cases be possible to design or select a stage-2 scaling strategy that is expected to yield a desired, relatively high level of error performance.

We will now comment on methodologies for defining a scaling function. As explained above in reference to FIG. 1, the check-node output Le, sent from the $j$th check node to the ith variable node in each iteration of the scaled MS algorithm, is derived from the quantity, Min $|L_{in}|$ $= \min_{i' \neq i} \left| M_{j \leftarrow i'}^{(k-1)} \right|$ . More specifically, the check node output Le is a scaled version of the quantity Min $|L_{in}|$, but with a sign obtained by multiplying together the signs of all of the messages input to check node $j$ from every variable node in its neighborhood *except for* variable node i.

That is, Le is a scaled version L' of the quantity $L = E_{j \rightarrow i}^{(k)} = \prod_{i' \neq i} \text{sgn}\left( M_{j \leftarrow i'}^{(k-1)} \right) \text{Min} |L_{in}|$ , obtained by a mapping of this quantity under a scaling function $f(L)$. The scaling function $f(L)$ may be non-linear. It may depend on the edge under consideration, on the iteration number, and on the channel SNR.

The inventors believe that one way to find a suitable scaling function $f(L)$ is to choose one that satisfies the following condition, which is discussed in the above-cited publication by Alvarado et al.:

$$L' = \log \frac{\Pr(L|c=1)}{\Pr(L|c=0)} = f(L) .$$

Here, c is the value of the variable node connected to the edge. More specifically, "$c=1$" is the hypothesis that the true value of the transmitted bit is 1, and "$c=0$" is the hypothesis that the true value of the transmitted bit is 0. The conditional distribution of $L$ can be obtained from the DDE at each iteration. The function $f(L)$ determines the LUT.

As mentioned above, the stage-2 decoding strategy is desirably designed for a greater number of iterations than the stage-1 decoding strategy. To achieve this, one could, for example, design the stage-1 scaling function by running the DDE at a larger of two SNR values, so that convergence is obtained in a smaller number of iterations, and by computing the corresponding function $f(L)$. The same procedure could be repeated at a lower SNR value, so that convergence is obtained in a larger number of iterations, and thus using the corresponding function $f(L)$ as the cautious scaling function.

It is noteworthy that often, hardware constraints limit the allowed number of iterations. A designer of a decoding algorithm would typically aim for the lowest convergence SNR threshold that is attainable under this constraint. Accordingly, the designer would aim for a LUT suitable for reaching this constrained objective.

**Example**

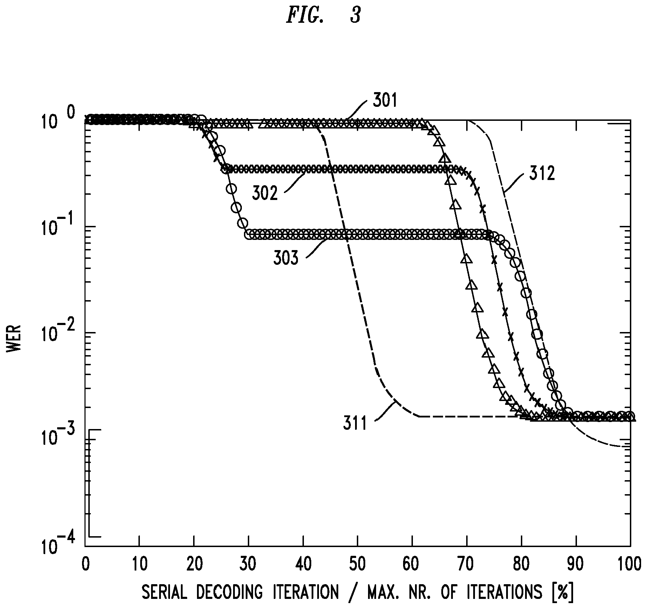

FIG. 3 is a graph showing the evolution of the word error rate (WER) as the relative number of iterations increases. The WER is plotted as a function of progress toward a reference number, which is a maximum number of iterations. The progress is expressed as the ratio, in percent, of the current serial iteration number to the reference number. The data are for a serial-C, doubly scaled Min-Sum (DS-MS) decoder at a reference channel SNR that is the same for all three plots.

Three sets of data have been plotted in FIG. 3. To generate each of the plots, first-stage decoding was performed with an LUT designed with DDE for three cases. The characteristic number of iterations in the decoding strategy increases from case to case in the order, Case I (curve 301), Case II (curve 302), Case III (curve 303). The first-stage decoding was followed by second-stage decoding with fixed scaling.

For comparison, we have also plotted the WER obtained in a single decoding stage, at the same channel quality, with an LUT designed with DDE for 60% (curve 311) and for 100% (curve 312) of the maximum number of iterations.

The figure shows that all three of the double-scaled schemes reach the same final WER of about $1.6 \times 10^{-3}$ that is achieved by the 60% single-stage decoder (curve 311). However, it will be seen that the doubly-scaled decoders obtain this result in two steps. That is, a fraction of the received codewords are decoded earlier, after 20%-30% of the reference number of iterations, whereas the rest are corrected after 65%-85% of the maximum number of iterations.

The fraction of early-decoded codeword is clearly largest (90%) for curve 303, which corresponds to Case III with the largest characteristic number of iterations. By contrast, the two-stage decoding is almost irrelevant for Case I (curve 301).

It is notable in this regard that, given a particular target SNR for the communication channel, it is possible to seek a tradeoff between the characteristic number of iterations in the stage-1 decoding and the characteristic number of iterations in the stage-2 decoding that best economizes on the total number of decoding iterations. Such a tradeoff can be sought, for example, by using simulations.

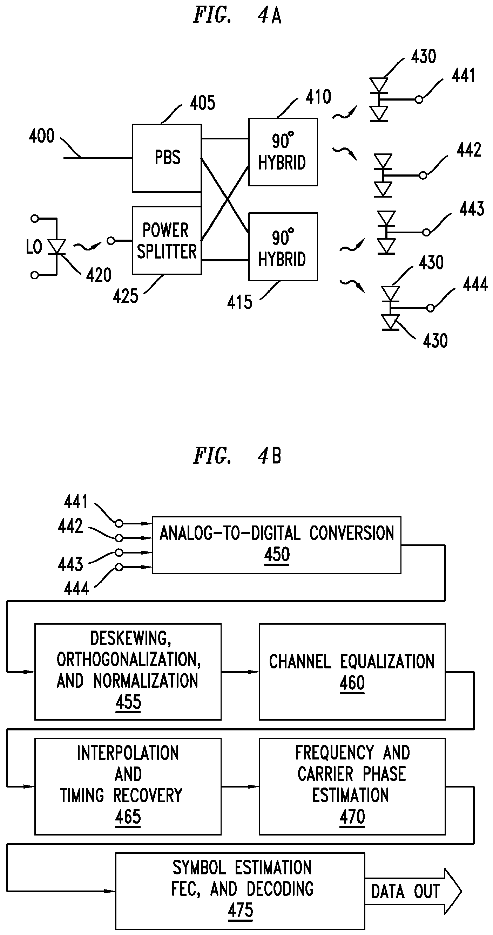

System implementation. FIG. 4A is a simplified, functional block diagram showing the optical front end of a polarization and phase diversity, coherent optical receiver in a non-limiting example. FIG. 4B is a simplified, functional block diagram of the functional subsystems of a coherent optical receiver that may be implemented in a digital signal processor (DSP). The functional subdivision represented in FIG. 4B is only one possible illustrative example, and is not meant to be limiting.

Turning first to FIG. 4A, the receiver is shown as having an input port 400 for connecting an input optical fiber to a polarization beam splitter (PBS) 405, which directs different polarization components of the input optical signal to 90° hybrid 410 and to 90° hybrid 415, respectively. A laser 420 provides a local oscillator signal, which is coupled into optical power splitter 425. The power splitter directs a portion of the local oscillator signal to each of the two 90° hybrids. Each hybrid mixes the incoming optical signal, at one of the two respective polarizations, with the optical signal from the local oscillator. The optically mixed signals are directed to the photodiodes 430 for coherent optical-to-electrical transduction. The photodiodes are shown in the present example as organized into four pairs of balanced photodetectors, having respective outputs 441-444. Effectively, these four outputs provide an in-phase signal channel and a quadrature signal channel for each of the two polarization components. These four output signals are analog electrical signals.

Turning now to FIG. 4B, the four outputs 441-444 are shown coupled into functional block 450, which performs analog-to-digital conversion (ADC). The digital output from block 450 is processed at block 455 for deskewing, orthogonalization, and normalization. These operations are for temporal alignment of the digital signals, maximization of signal-to-signal independence, and correction of signal amplitude. The output from block 455 is digitally equalized at block 460 to correct for channel impairments, processed at interpolation and timing recovery block 465 to correct for timing errors, and processed at frequency and carrier phase estimation block 470 to compensate for carrier phase error.

At block 475, the conditioned and corrected signal, as digitally demodulated at blocks 455-470, undergoes symbol estimation, forward error correction, and decoding to produce a signal output representing a best estimate of the bit sequence encoded by the transmitter. Forward error correction and decoding, may, for example, be performed in accordance with the methods described hereinabove.

**Claims**

1. A method for decoding a plurality of codewords from a received binary bitstream, comprising:

   in a first decoding stage, processing each of the codewords in said plurality with a first iterative decoding algorithm based on forward error-correction information of the codewords; and
   in a second decoding stage, processing selected ones of the codewords of said plurality with a second iterative decoding algorithm based on forward error-correction information in the selected ones of the codewords, wherein:

   the selected ones of the codewords are each selected in response to the decoding of one of the codewords, in the first decoding stage, being exited without producing a decoded codeword; and
   the second iterative decoding algorithm is configured to enable a greater number of iterations of decoding per codeword than the first iterative decoding algorithm.

2. The method of claim 1, wherein each of the selected ones of the codewords is selected in response to an indication, in the processing of the first decoding stage, that a preset maximum number of iterative decoding attempts has been made thereon without producing a successful decoding.

3. The method of claim 1, wherein the codewords from the received binary bitstream are LDPC-encoded codewords.

4. The method of claim 1, wherein the processing of the first decoding stage further comprises:

   periodically checking individual ones of the codewords during the processing of the first decoding stage to determine whether decoding thereof has been successful; and
   for each individual one of the codewords, exiting the processing of the first decoding stage upon the earlier of: a determination that the individual one of the codewords has been successfully decoded, and a determination that a preset maximum number of decoding iterations has been reached for the individual one of the codewords.

5. The method of claim 1, wherein the first decoding stage and the second decoding stage each process codewords with a scaled MS decoding algorithm.

6. The method of claim 1, wherein:

   the first decoding stage and the second decoding stage each process codewords with a scaled MS decoding algorithm having a respective scaling strategy; and
   the scaling strategy for the second decoding stage is designed to enable a greater number of decoding iterations than the scaling strategy for the first decoding stage.

7. The method of claim 1, wherein at least one of the first and second decoding stages uses flood scheduling or sequential scheduling.

8. The method of claim 1, wherein at least the second decoder uses dynamic scaling.

9. The method of claim 1, wherein the second decoding stage is designed to decode with a smaller error rate than the first decoding stage, at a given channel quality.

10. The method of claim 1, wherein:

    the first decoding stage processes codewords with a scaled MS decoding algorithm that takes values indicative of a scaled posterior LLR from a first look-up table (LUT);
    the second decoding stage processes codewords with a scaled MS decoding algorithm that takes values indicative of a scaled posterior LLR from a second look-up table (LUT);
    the first and second LUTs are each designed to implement a respective scaling strategy; and
    the scaling strategy implemented by the second LUT enables a greater number of decoding iterations per codeword than the scaling strategy implemented by the first LUT.

11. The method of claim 1, wherein:

each codeword of said plurality that is in-process in the first decoding stage undergoes at least one decoding iteration;

each decoding iteration in the first decoding stage updates posterior LLR values for bits of the in-process codeword; and

before any selected one of the codewords is processed with the second iterative decoding algorithm, the bits of the selected one of the codewords are reset to initial LLR values with which said bits were associated prior to processing in the first decoding iteration in the first decoding stage.

**12.** The method of claim 1, further comprising:

in a coherent optical receiver, converting a received, LDPC-encoded, data-modulated optical signal to said binary bitstream; and

advancing the binary bitstream to the first decoding stage.

**13.** Apparatus, comprising:

a decoder circuit configured to decode codewords using an algorithm performed in decoding iterations; and

a codeword memory configured to store a portion of the codewords in response to said portion having failed to be decoded by the decoder circuit, in a first decoding stage, after a preset maximum permitted number of the decoding iterations of the algorithm;

wherein the decoder circuit is configured to process codewords of said stored portion in a second decoding stage in response to retrieving the codewords of said portion from the codeword memory.

**14.** The apparatus of claim 13, wherein:

the decoder circuit is further configured to exit the decoding iterations on each codeword that is in-process in the first decoding stage upon the earlier of: determining that the in-process codeword has been successfully decoded, and determining that a preset maximum permitted number of decoding iterations has been reached thereon; and

the decoder circuit is further configured to store the in-process codeword in the codeword memory for processing in the second decoding stage, if the preset maximum permitted number of decoding iterations has been reached thereon.

**15.** The apparatus of claim 13, further comprising:

a memory for storing a first look-up table (LUT) and a second look-up table (LUT); and

an LUT circuit configured to retrieve a set of values indicative of scaled posterior LLRs from the first look-up table memory and to retrieve a different set of values indicative of scaled posterior LLRs from the second look-up table memory, wherein:

the LUT circuit is further configured to provide values from the first LUT to the decoder circuit for use in the first decoding stage, and to provide values from the second LUT to the decoder circuit for use in the second decoding stage;

the LUT circuit is further configured to reset bits of each codeword retrieved from the codeword memory to initial LLR values before each said retrieved codeword is processed in the second decoding stage; and

for each retrieved codeword, the initial values are respective values that the bits of the retrieved codeword had prior to the processing thereof in the first decoding stage.

*FIG. 1*

*FIG. 2*

FIG. 3

*FIG.* *4*A

*FIG.* *4*B

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WANG RUOTONG ET AL: "Hierarchical Min-Sum Algorithm Based on Dynamic Scaling Factor for LDPC Decoding", PROC., ASIA COMMUNICATIONS AND PHOTONICS CONFERENCE (ACP), OSA, 24 October 2021 (2021-10-24), pages 1-3, XP034105972, DOI: 10.1364/ACPC.2021.T4A.39 | 1-10, 12-15 | INV. H03M13/11 H03M13/37 |
| A | * page 1 - page 2 * | 11 | |
| X | US 2017/093428 A1 (YEN JOHNSON [US] ET AL) 30 March 2017 (2017-03-30) * paragraph [0027] - paragraph [0061]; figures 3,5 * | 1-15 | |
| X | TORSHIZI EHSAN OLYAEI ET AL: "A new hybrid decoding algorithm for LDPC codes based on the improved variable multi weighted bit-flipping and BP algorithms", PROC., 21ST IRANIAN CONFERENCE ON ELECTRICAL ENGINEERING (ICEE), IEEE, 14 May 2013 (2013-05-14), pages 1-6, XP032483303, DOI: 10.1109/IRANIANCEE.2013.6599566 [retrieved on 2013-09-13] | 1-4,7,9, 12-14 | |
| A | * page 1 - page 5 * | 5,6,8, 10,11 | TECHNICAL FIELDS SEARCHED (IPC) H03M |
| X | US 2010/192040 A1 (YEDIDIA JONATHAN S [US] ET AL) 29 July 2010 (2010-07-29) | 1-4,7,9, 11-14 | |
| A | * abstract * * paragraph [0021] - paragraph [0034]; claim 1; figure 1 * * paragraph [0065] - paragraph [0076] * | 5,6,8,10 | |

-/--

The present search report has been drawn up for all claims

| Place of search | Date of completion of the search | Examiner |
|---|---|---|
| Munich | 16 November 2022 | Offer, Elke |

EPO FORM 1503 03.82 (P04C01)

page 1 of 2

Europäisches
Patentamt

European
Patent Office

Office européen
des brevets

## EUROPEAN SEARCH REPORT

Application Number

EP 22 17 7819

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CHEN J ET AL: "Density evolution for two improved BP-Based decoding algorithms of LDPC codes", IEEE COMMUNICATIONS LETTERS, IEEE SERVICE CENTER, PISCATAWAY, NJ, US, vol. 6, no. 5, 1 May 2002 (2002-05-01), pages 208-210, XP011423628, ISSN: 1089-7798, DOI: 10.1109/4234.1001666 * the whole document * ----- | 1-15 | |

| | | TECHNICAL FIELDS SEARCHED (IPC) |
|---|---|---|
| | | |

The present search report has been drawn up for all claims

| Place of search | Date of completion of the search | Examiner |
|---|---|---|
| Munich | 16 November 2022 | Offer, Elke |

EPO FORM 1503 03.82 (P04C01)

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## ANNEX TO THE EUROPEAN SEARCH REPORT
## ON EUROPEAN PATENT APPLICATION NO.

EP 22 17 7819

This annex lists the patent family members relating to the patent documents cited in the above-mentioned European search report.
The members are as contained in the European Patent Office EDP file on
The European Patent Office is in no way liable for these particulars which are merely given for the purpose of information.

16-11-2022

| Patent document cited in search report | Publication date | Patent family member(s) | Publication date |
|---|---|---|---|
| US 2017093428 A1 | 30-03-2017 | NONE | |
| US 2010192040 A1 | 29-07-2010 | CN 101814975 A | 25-08-2010 |
| | | JP 5464990 B2 | 09-04-2014 |
| | | JP 2010178328 A | 12-08-2010 |
| | | US 2010192040 A1 | 29-07-2010 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **A. ALVARADO et al.** Correcting Suboptimal Metrics in Iterative Decoders. *2009 IEEE International Conference on Communications,* 2009, 1-6
- **E. SHARON ; S. LITSYN ; J. GOLDBERGER.** Efficient Serial Message-Passing Schedules for LDPC Decoding. *IEEE Transactions on Information Theory,* November 2007, vol. 53 (11), 4076-4091

- **EMNA BEN YACOUB.** Matched Quantized Min-Sum Decoding of Low-Density Parity-Check Codes. *Proc. 2020 IEEE Information Theory Workshop (ITW),* 11 April 2021
- **A. BALATSOUKAS-STIMMING ; A. BURG.** Density evolution for min-sum decoding of LDPC codes under unreliable message storage. *IEEE Commun. Letters,* May 2014, vol. 18 (5), 849-852